# EUROPEAN PATENT APPLICATION

(11) **EP 1 077 593 A2**
(43) Date of publication of application: **21.02.2001**
(21) Application number: 00202891.8
(22) Date of filing: 17.08.2000
(51) Int. Cl.: H05K 13/08

(54) **Method and apparatus for obtaining an image of a component using a mirror**

(30) Priority: 18.08.1999 US 376523
(71) Applicant: UNIVERSAL INSTRUMENTS CORPORATION, Binghamton, New York 13902-0825 (US)
(72) Inventor: Danek, John E., Vestal, New York 13850 (US)
(74) Representative: Eveleens Maarse, Pieter

(57) **Abstract**

An optical system (10) and method for obtaining an image of a component (1). The optical system includes an image capture device (30), such as a camera, for obtaining an image of the component and a component pickup head (20) adapted to hold and move the component to an image acquisition position, which is outside the field of view of the camera. A mirror (12) is movable within the plane of its reflective surface between two positions. In the first position an image of the component is not reflected into the field of view of the camera, and in the second position an image of said component is reflected into said field of view of said camera.

## Description

### FIELD OF THE INVENTION

The present invention relates to a method and apparatus for obtaining an image of a component using a movable mirror or other reflective surface.

### BACKGROUND OF INVENTION

In the automatic placement of electronic components, the components are picked, for example, by a spindle placement head from a supply of components to be placed on a printed circuit board. To ensure the proper placement of the components, and, in particular, the leads of the component on the circuit board, the positioning and alignment of the leads is checked for each component prior to placement on the circuit board. This is typically accomplished by acquiring an image of the component leads prior to placement using a machine vision system.

Because the leads of a component to be placed typically project downward when the components is held by the placement head, it is necessary to obtain an image of the component from the bottom. In the past an upwardly looking camera has been used. However, this required moving the component to the camera at a dedicated location before moving the component to the proper location for placement. This resulted in longer cycle times and a corresponding reduction of throughput.

More recently, moveable mirrors have been employed with horizontally oriented cameras to reduce cycle time and increase throughput. In such prior art systems, a mirror or mirrors are mounted along with a camera to a carriage which moves in the X and Y directions with the placement head. To obtain an image of the component, the mirror is moved beneath the component just prior to the component being placed on the circuit board. The mirror reflects an image of the bottom of the component into the field of view of the camera so that the camera can acquire an image of the leads. The mirror is then moved out of the placement head path and the placement head is lowered to place the component on the board below. These systems thereby reduced cycle time by minimizing the travel of the component. However, because the mirror in such systems was moved at an angle oblique to the plane defined by its reflective surface, these systems are subject to errors caused by movement of the mirror. For example, if the mirror is not completely in position when the image is acquired or if repeatability of mirror positioning is an issue, accuracy of lead imaging suffered.

### SUMMARY OF THE INVENTION

It is, therefore, an object of the present invention to provide an improved optical system for obtaining an image of a component.

Another object of the present invention is to provide an optical system for obtaining an image of the bottom of a component using a non-upwardly looking camera.

Yet another object of the present invention is to provide an optical system for obtaining an image of a component using a moveable mirror which minimizes errors introduced by mirror movement.

A further object of the invention is to provide an improved method for acquiring an image of a component using a movable reflective surface.

The above and other objects are achieved in accordance with a first aspect of the present invention by an optical system for obtaining an image of a component. The optical system includes an image capture device, such as a camera, for obtaining an image of the component. A component pickup head holds and moves the component to an image acquisition position, which is outside the field of view of the camera. A mirror is movable within the plane of its reflective surface between two positions. In the first position an image of the component is not reflected into the field of view of the camera, and in the second position an image of the component is reflected into said field of view of the camera.

In another aspect of the present invention an image of a component is obtained using an image capture device such as a camera. The component is moved to an image acquisition position, which is outside the field of view of the camera. A mirror is moved within the plane of its reflective surface from a first position to a second position. In the first position an image of the component is not reflected into the field of view of the camera. In the second position an image of said component is reflected into the field of view of the camera.

These and other objects, features and advantages of the present invention will be apparent and fully understood from the following detailed description of the preferred embodiments, taken in connection with the appended drawings in which like reference numerals describe corresponding features.

### BRIEF DESCRIPTION OF THE DRAWINGS

Figure 1 is an elevational view of an optical system according to an aspect of the present invention.
Figure 2 is an elevational view of the optical system of Figure 1 with the moveable mirror in position to reflect an image of the component to the camera.
Figure 3 is an elevational view of the optical system of Figure 1 with the moveable mirror in position to allow the placement head to place the component on the printed circuit board.
Figure 4 is a planar view of a rotating disk having an alternating series of reflective surfaces and cut out regions in accordance with another aspect of the present invention.
Figure 5 is an elevational view of an optical system according to an aspect of the present invention including the rotating disk of Figure. 4.

### DETAILED DESCRIPTION OF THE PREFERRED EMBODIMENT

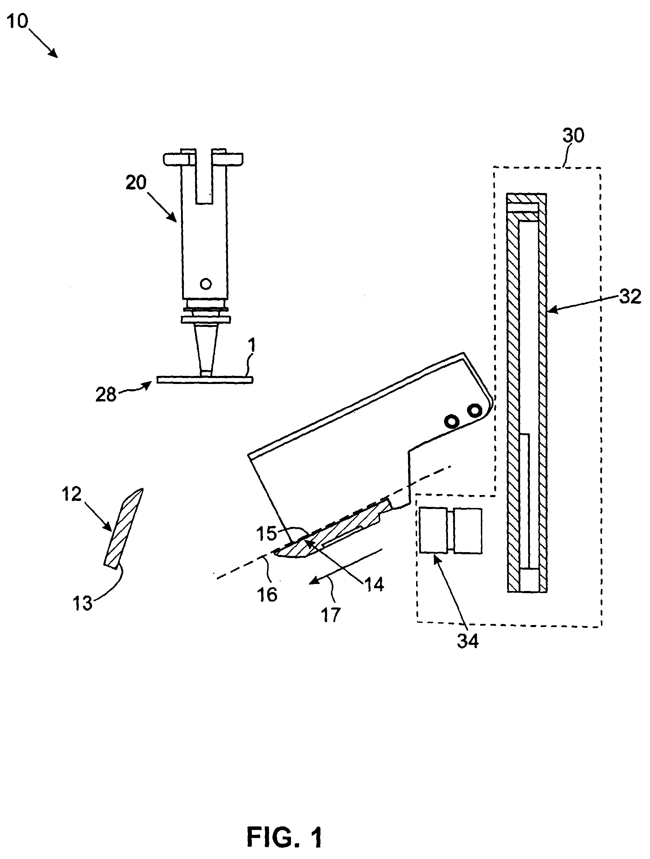

Referring first to Figure 1, an optical system 10 according to the present invention is illustrated. Also shown is a placement head 20 holding a component 1. The optical system with placement head is used as part of an electronic assembly machine, known in the art as a "pick and place" machine. An example of such a pick and place machine is the GSM™ component placement machine manufactured and sold by Universal Instruments Corp. of Binghamton, New York. The structure and operation of that machine, which is well known in the art, is incorporated herein by reference in its entirety.

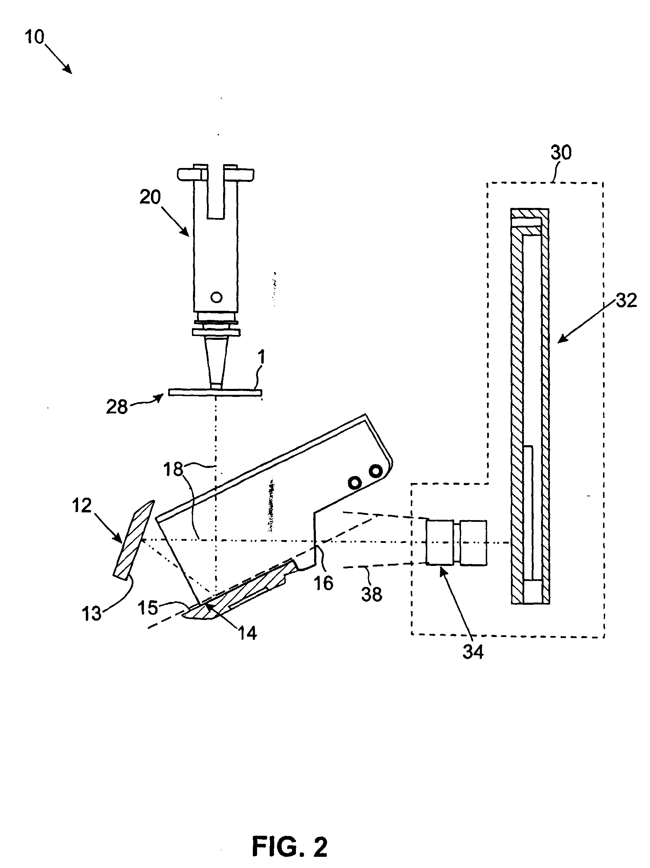

The placement head 20, having previously been lowered to pick up the component 1 from a component supply station on the pick and place machines is raised and held at an image acquisition position 28, shown in Fig. 1. An image capture device 30 is mounted adjacent the the image acquisition position 28 for example, to the frame of a carriage (now shown) on the pick and place machine which moves in the X and Y directions with the placement head 20. The orientation of the image capture device 30 is such that the field of view 38 (see Fig. 2) is in essence perpendicular to the plane of the bottom surface of the component. The image capture device 30 of the illustrated embodiment is a CCD camera 32 with a lens system 34 for focusing light from a field of view 38 onto the CCD camera 32. Other types of image capture devices are well known in the art of electronic component assembly systems. Because the image capture device 30 is horizontally oriented, the image of the bottom of the component 1 is not projected directly onto the camera 32.

Positioned in front of the camera 32 and in its field of view 38 on the opposite side of the image acquisition position 28 is a mirror 12. The mirror 12 is also mounted to the carriage frame or to some other support on the pick and place machine such that the mirror 12 moves with the image capture device 30. The mirror 12 may be positioned, for example, at an angle of 78° relative to the horizontal axis.

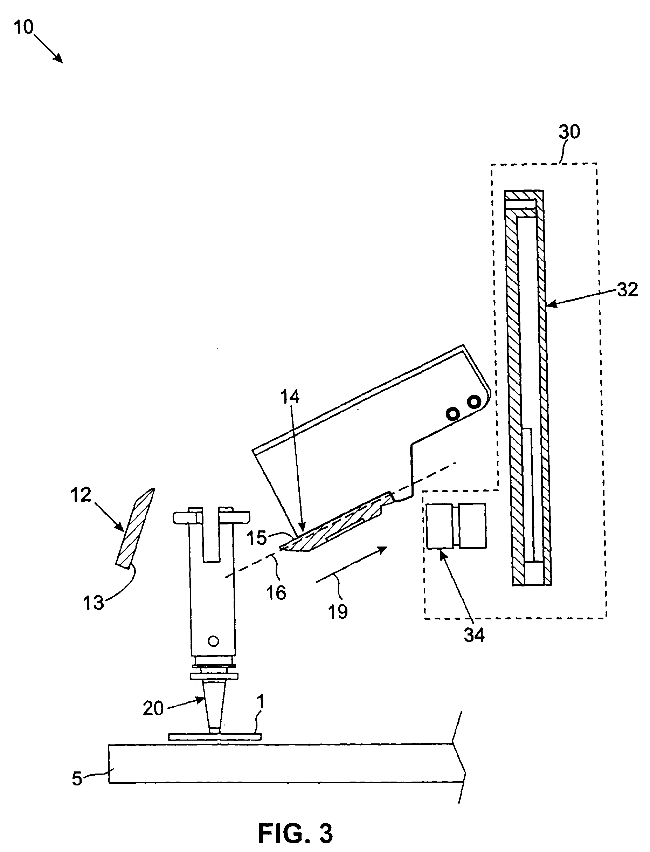

A second mirror 14 is positioned between the mirror 12 and the camera 32. The second mirror 14 is also mounted, for example, to the frame of the carriage, however, it is moveable within the plane 16 defined by its reflective surface 15 between a first position (shown in Figures 1 and 3) and a second position (shown in Figure 2). The second mirror 14 may be positioned, for example, at an angle of 22° relative to the horizontal axis. As shown in Figures 1 and 3, when the movable mirror 14 is in the first position, the path below the placement head 20 is clear so that the placement head 20 may be lowered to pick components from a supply and also to deposit the components 1 on circuit boards 5. When in the second position, the moveable mirror 14 is located below the component 1, in the path between the component 1 and the printed circuit board 5 or component supply. In the illustrated embodiment, the moveable mirror 14 is mounted to the carriage through a set of precision bearings so as to ensure smooth movement within the plane 16 and is driven between the two positions by a cable drive system, although other drives (e.g. electric motors, gears, belts, rack and pinion system, pneumatic device) may also be used.

As seen in Figure 2, the angular orientation of the mirrors 12 and 14 is selected such that when the moveable mirror 14 is in the second position below the component 1, an image of the bottom of the component 1 is reflected off of reflective surface 15 of mirror 14 to the reflective surface 13 of mirror 12, and then to the camera 32 in its field of view 38. Further, because the moveable mirror 14 is only moved relative to the camera 32 and component 1 within the plane 16 of its reflective surface 15, the optical path 18 remains essentially the same as the mirror 14 moves into position. Thus, the only errors introduced by the optical system 10 are reduced to the flatness of the mirror 14, the rumble of the mirror bearings and the cosine error of the mirror plane and axis.

In operation, a component 1 to be placed is picked-up and held by the placement head 20 using one of the methods well known in the art (e.g. vacuum). The component 1 is then raised to the image acquisition position 28 (Figure 1). Once the component is raised to the image acquisition position (or while moving to that position), the moveable mirror 14 is slid from the first position to the second position as indicated by arrow 17. As shown in Figure 2, this completes the optical path 18 reflecting an image of the component 1 to the camera 32 to be captured. Because the mirror 14 is moved relative to the camera 32 and component 1 only within the plane 16 of its reflective surface 15, the image of the component 1 can be captured without having to wait for the mirror 14 to reach the end of its travel. Once the image has been captured by the camera 32, the mirror 14 is returned to the first position, as shown by arrow 19 in Figure 3. This clears the path below the placement head 20 so that it can place the component 1 on the printed circuit board 5 and pick a next component from the component supply, thus repeating the process already outlined.

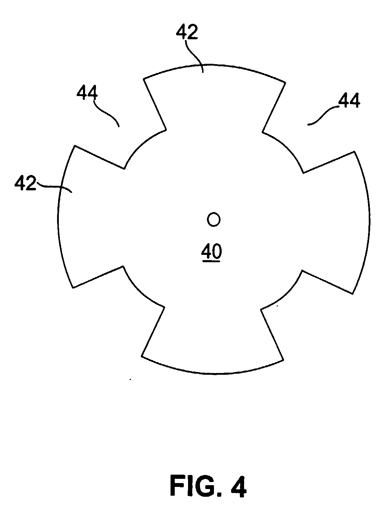

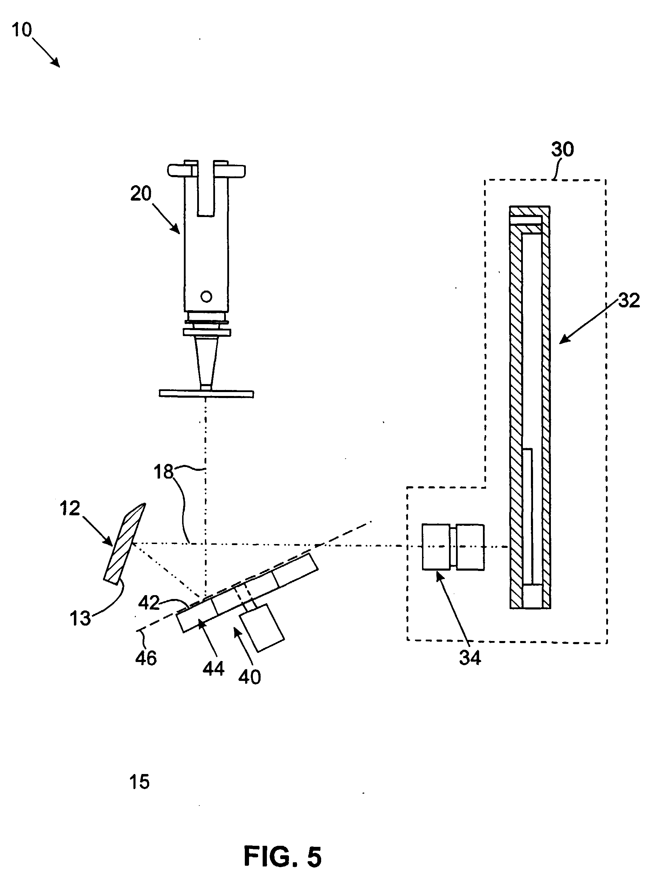

While the present invention is described in terms of using a sliding mirror 14, it should be understood to describe any means of providing a reflective surface, provided the reflective surface is moved within the plane defined by that surface. Likewise, other means of moving the mirror may be substituted for that described herein. For example, in one alternative embodiment, illustrated in Figures 4 and 5, a rotating disk 40 having an alternating series of reflective surfaces 42 and cut out regions 44 may be used. By controllably rotating the disk 40, an image of the component 1 may be reflected by one of the reflective surfaces 42, which is then rotated to allow the placement head 20 to pass through the cut out region 44. Again, because the reflective surfaces 42 are moved within the plane 46 defined by the reflective surfaces 42, the errors in imaging introduced by the optical system are significantly reduced. The disk may be driven by means of a rotary drive mechanism such as a motor or rotary air cylinder.

Alternate arrangements of a single or plurality of mirrors or reflective surfaces may also be used in connection with the present invention,

The present invention has been described in terms of illustrated embodiments thereof. Other embodiments, features and variations within the scope of the appended claims will, given the benefit of this disclosure, occur to those having ordinary skill in the art.

## Claims

1. An optical system for obtaining an image of a component comprising:
an image capture device having a field of view;
a component pickup head adapted to hold said component and move said component to and from an image acquisition position, said image acquisition position being outside said field of view of said image capture device;
a mirror disposed in a first plane, and movable within said first plane from a first position wherein an image of said component is not reflected into said field of view of said image capture device, and a second position wherein an image of said component is reflected into said field of view of said image capture device.

2. The optical system of claim 1 wherein said mirror is a first mirror, said optical system further comprising a second mirror positioned such that said component image is reflected into said field of view of said image capture device by an optical path including said first mirror and said second mirror.

3. The optical system of claim 1 wherein said mirror is mounted so as to slide between said first and second positions.

4. The optical system of claim 1 wherein said mirror is mounted so as to rotate between said first and second positions.

5. The optical system of claim 4 wherein said mirror comprises a plurality of reflective sections separated by a plurality of gaps along a periphery of the mirror.

6. The optical system of claim 1 further comprising at least one light source disposed proximate said image acquisition position so as to cast light on said component when located at said image acquisition position.

7. An optical system for obtaining an image of a component comprising:
an image capture device having a field of view;
a component pickup head adapted to hold said component and move said component to and from an image acquisition position; and
a first mirror disposed in a first plane and movable within said first plane from a first position wherein an image of said component is not reflected to said image capture device, and a second position wherein an image of said component is reflected to said image capture device.

8. The optical system of claim 7 further comprising a second mirror positioned such that said component image is reflected to said first image capture device by an optical path including said first mirror and said second mirror.

9. The optical system of claim 7 wherein said first mirror is mounted so as to slide between said first and second positions.

10. The optical system of claim 7 further comprising at least one light source disposed proximate said image acquisition position so as to cast light on said component when located at said image acquisition position.

11. An optical system for obtaining an image of a component comprising:
means for capturing an image of said component in a field of view;
means for moving said component to and from an image acquisition position, said image acquisition position being outside said field of view of said image capture means; and
means for selectively reflecting an image of said component into said field of view of said image capture means.

12. The optical system of claim 11 wherein said reflecting means comprises:
a mirror disposed in a first plane; and
means for moving said mirror within said first plane between a first position wherein an image of said component is not reflected into said field of view of said image capture means, and a second position wherein an image of said component is reflected into said field of view of said image capture means.

13. The optical system of claim 11 further comprising means for illuminating said component.

14. A method of obtaining an image of a component comprising:
providing an image capture device having a field of view;
moving said component to an image acquisition position, said image acquisition position being outside said field of view of said image capture device;
providing a mirror disposed in a first plane;
moving said mirror in said first plane from a first position wherein an image of said component is not reflected into said field of view of said image capture device, to a second position wherein an image of said component is reflected into said field of view of said image capture device.

15. The method for obtaining an image of claim 14 further comprising illuminating said component.
